# EUROPEAN PATENT APPLICATION

(11) **EP 4 435 438 A1**
(43) Date of publication of application: **25.09.2024**
(21) Application number: 23901742.9
(22) Date of filing: 27.11.2023
(51) Int. Cl.: G01R 15/20, G01R 15/00

(54) **CURRENT DETECTOR**

(30) Priority: 27.12.2022 JP 2022210483
(71) Applicant: Suncall Corporation, Kyoto-shi, Kyoto 615-8555 (JP)
(72) Inventor: MURAKAMI, Kenji, Kyoto-shi, Kyoto 615-8555 (JP)
(74) Representative: Hoffmann Eitle
(86) International application number: PCT/JP2023/042306
(87) International publication number: WO 2024/142703

(57) **Abstract**

Provided is a current detector that can provide redundancy and mutually complement disadvantages of current sensors with different detection methods.

The current detector has a bus bar 2 through which a current I to be measured flows. In the bus bar 2, the current I flows from a right side surface 21d side toward a left side surface 20c side. A shunt resistor 3 and a magnetic sensor 4 detecting the current I by different detection methods are provided on a path of the bus bar 2 through which the current I flows. The shunt resistor 3 allows the current I flowing through the bus bar 2 to flow through a resistive element 30 and detects the magnitude of the current from a voltage across the resistive element. The magnetic sensor 4 detects a magnetic-field component M generated by the current I flowing through the bus bar 2.

## Description

### Technical Field

The present invention relates to a current detector.

### Background Art

Conventionally, a shunt resistor (see, for example, Patent Literature 1) is known as a contact type current sensor, and a magnetic sensor (see, for example, Patent Literature 2) is known as a non-contact type current sensor.

Incidentally, in recent years, there has been an increasing demand to provide redundancy using current sensors with different detection methods so that, even if one current sensor is damaged, current detection can be continued using another current sensor.

Accordingly, in order to meet such a demand, a method has been proposed to provide redundancy by arranging the shunt resistor and the magnetic sensor in parallel (see, for example, Patent Literature 3).

### Citation List

### Patent Literature

Patent Literature 1: Japanese Published Unexamined Patent Application No. 2021-190543
Patent Literature 2: Japanese Published Unexamined Patent Application No. 2010-014477
Patent Literature 3: Japanese Published Unexamined Patent Application No. 2020-091261

### Summary of the Invention

### Technical Problem

However, the method as described above can provide redundancy but has a problem in that the installation space increases.

In addition, the shunt resistor has a disadvantage of being susceptible to the heat generated by the current flowing through the bus bar although the installation space can be reduced, and the magnetic sensor has a disadvantage that the installation space increases although being less susceptible to the heat generated by the current flowing through the bus bar. However, the method as described above has a problem in that none of the disadvantages can be solved.

Accordingly, in view of the foregoing problem, an object of the present invention is to provide a current detector that can provide redundancy and mutually complement the disadvantages of the current sensors with different detection methods.

### Solution to the Problem

The foregoing object of the present invention is achieved by the following means. It is noted that reference signs in an embodiment to be described later are added in parentheses, but the present invention is not limited thereto.

According to a first aspect of the present invention, a current detector (1, 1A) having a bus bar (2, 2A) through which a current (I) to be measured flows is characterized in that current sensors (shunt resistor 3, magnetic sensor 4) detecting the current (I) by different detection methods are provided on a path of the bus bar (2, 2A) through which the current (I) flows from one end surface (right side surface 21d, 21Ad) side toward another end surface (left side surface 20c) side of the bus bar (2, 2A).

According to a second aspect of the present invention, the current detector (1, 1A) set forth in the above first aspect is characterized in that the current sensors include a magnetic sensor (4) detecting a magnetic-field component (M) generated by the current (I) flowing through the bus bar (2, 2A), and a shunt resistor (3) allowing the current (I) flowing through the bus bar (2, 2A) to flow through a resistive element (30) and detecting a magnitude of the current from a voltage across the resistive element (30).

According to a third aspect of the present invention, the current detector (1, 1A) set forth in the above second aspect is characterized in that the magnetic sensor (4) is provided at a linearly-formed position in the path of the bus bar (2, 2A). Advantageous Effects of the Invention

Next, advantageous effects of the present invention will be described with reference signs in the drawings. It is noted that reference signs in an embodiment to be described later are added in parentheses, but the present invention is not limited thereto.

According to the first aspect of the present invention, since the current sensors (shunt resistor 3, magnetic sensor 4) detecting the current (I) by different detection methods are provided on the path of the bus bar (2, 2A) through which the current (I) flows from the one end surface (right side surface 21d, 21Ad) side to the other end surface (left side surface 20c) side, the current detector can provide redundancy and mutually complement the disadvantages of the current sensors with different detection methods. As these current sensors performing detection by different detection methods, the magnetic sensor (4) detecting the magnetic-field component (M) generated by the current (I) flowing through the bus bar (2, 2A) and the shunt resistor (3) allowing the current flowing through the bus bar (2, 2A) to flow through the resistive element (30) and detecting the magnitude of the current from a voltage across the resistive element (30) according the second aspect of the present invention are suitable.

According to the third aspect of the present invention, since the magnetic sensor (4) is provided at a linearly-formed position in the path of the bus bar (2, 2A), processing such as applying shielding or casing is facilitated.

### Bried Description of the Drawings

[FIG. 1] FIG. 1(a) is a perspective view of a current detector according to an embodiment of the present invention and FIG. 1(b) is a longitudinal sectional view of the current detector according to the same embodiment.
[FIG. 2] FIG. 2 is a perspective view of a current detector according to another embodiment.

### Description of Embodiments

Hereinafter, an embodiment of a current detector according to the present invention will be specifically described with reference to the drawings. It is noted that, in the following description, when vertical and horizontal directions are indicated, it shall mean vertical and horizontal directions when viewed from the front of the figure.

### <Description of Current Detector>

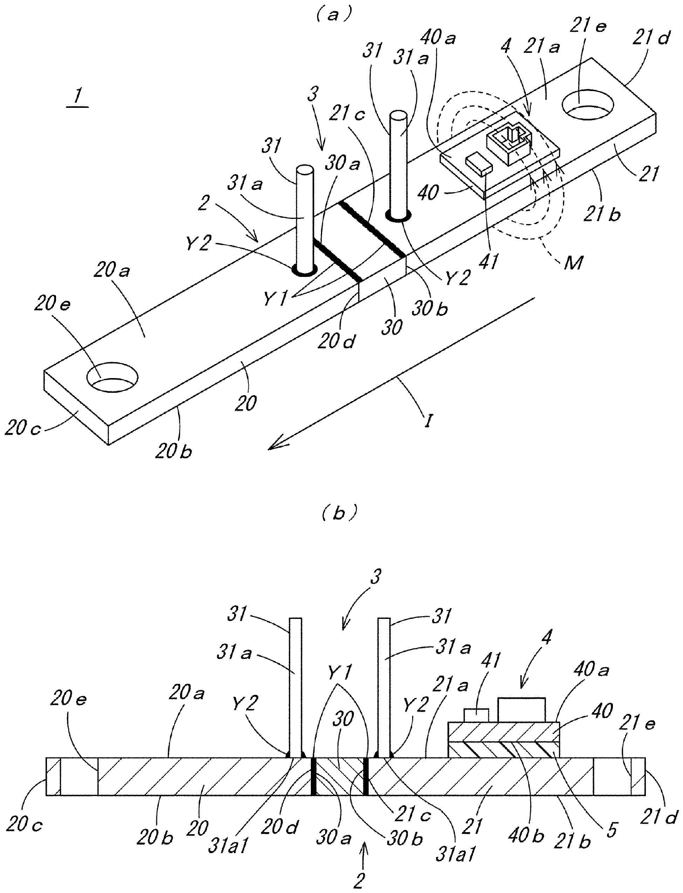

The current detector according to this embodiment is used in an inverter, a battery, or the like. As shown in FIG. 1, a current detector 1 is composed of a bus bar 2, a shunt resistor 3, and a magnetic sensor 4. In the following, each configuration will be described in detail.

### <Description of Bus Bar>

The bus bar 2 is made of metal such as copper, and as shown in FIG. 1, is formed, for example, in the shape of a thick plate with a thickness of about 3 mm to 5 mm, and is composed of a left bus bar 20 and a right bus bar 21. As shown in FIG. 1(a), the left bus bar 20 is formed in a long rectangular shape consisting of an upper surface 20a, a lower surface 20b, a left side surface 20c, and a right side surface 20d. As shown in FIG. 1(b), on the left side surface 20c side of the left bus bar 20, a left through hole 20e having a circular shape (see FIG. 1(a)) for passing a shaft portion of a bolt (not shown) therethrough is provided so as to penetrate from the upper surface 20a toward the lower surface 20b of the left bus bar 20.

On the other hand, as shown in FIG. 1(a), the right bus bar 21 is formed in a long rectangular shape consisting of an upper surface 21a, a lower surface 21b, a left side surface 21c, and a right side surface 21d. As shown in FIG. 1(b), on the right side surface 21d side of the right bus bar 21, a right through hole 21e having a circular shape (see FIG. 1(a)) for passing a shaft portion of a bolt (not shown) therethrough is provided so as to protrude from the upper surface 21a toward the lower surface 21b of the right bus bar 21.

### <Description of Shunt Resistor>

The shunt resistor 3 is a contact type current sensor that allows the current flowing through the bus bar 2 described above to flow through a resistive element and detects the magnitude of the current from a voltage across the resistive element. More specifically, as shown in FIG. 1, the shunt resistor 3 is composed of a resistive element 30 and measurement terminals 31. As shown in FIG. 1(a), the resistive element 30 is formed, for example, in the shape of a thick plate with a thickness of about 3 mm to 5 mm and in a short rectangular shape, and is made of, for example, a Cu-Mn-based alloy, a Cu-Ni-based alloy, a Ni-Cr-based alloy, or the like. Thus, as shown in FIG. 1, such a resistive element 30 has its left side surface 30a joined to the right side surface 20d of the left bus bar 20 by welding Y1 and has its right side surface 30b joined to the left side surface 21c of the right bus bar 21 by welding Y1. The resistive element 30 is thereby sandwiched between the left bus bar 20 and the right bus bar 21 and is formed integrally with the bus bar 2.

On the other hand, the measurement terminal 31 can be mounted with a printed circuit board for current detection (not shown) thereon and is made of copper, tin plating, or the like. As shown in FIG. 1, the measurement terminal 31 is provided in pairs and further includes a rod-shaped shaft portion 31a. The shaft portion 31a is a voltage measurement terminal used when measuring a current value, and the diameter thereof is formed to be, for example, about 1 mm to 1.5 mm. As shown in FIG. 1(b), the shaft portion 31a of one of the pair of measurement terminals 31 has a lower surface 31a1 contacting the upper surface 20a on the right side surface 20d side of the left bus bar 20, and an outer peripheral surface on the lower surface 31a1 side of the shaft portion 31a is joined by welding Y2. Thereby, as shown in FIG. 1, the shaft portion 31a of one of the pair of measurement terminals 31 is provided in a standing state on the upper surface 20a on the right side surface 20d side of the left bus bar 20.

Also, as shown in FIG. 1(b), the shaft portion 31a of the other measurement terminal 31 of the pair of measurement terminals 31 has the lower surface 31a1 contacting the upper surface 21a on the left side surface 21c side of the right bus bar 21, and an outer peripheral surface on the lower surface 31a1 side of the shaft portion 31a is joined by welding Y2. Thereby, as shown in FIG. 1, the shaft portion 31a of the other measurement terminal 31 of the pair of measurement terminals 31 is provided in a standing state on the upper surface 21a on the left side surface 21c side of the right bus bar 21.

Thus, in this way, the shunt resistor 3 is provided on the path of the bus bar 2 through which a current I flows as shown in FIG. 1(a). That is, when the current I to be measured flows through the bus bar 2 installed in an inverter, a battery, or the like from the right side surface 21d side of the right bus bar 21 toward the left side surface 20c side of the left bus bar 20 as shown in FIG. 1(a), the current I flows through the resistive element 30 of the shunt resistor 3. Thereby, a voltage (potential difference) is generated at both ends of the resistive element 30, that is, the left side surface 30a and the right side surface 30b, and the pair of measurement terminals 31 each detect the voltage (potential difference). Thereby, the printed circuit board for current detection (not shown) mounted on the pair of measurement terminals 31 converts the voltage detected by each of the pair of measurement terminals 31 into a current, and the current value can be measured.

### <Description of Magnetic Sensor>

The magnetic sensor 4 is a non-contact type current sensor and detects a magnetic-field component generated by the current I (see FIG. 1(a)) flowing through the bus bar 2 described above. More specifically, as shown in FIG. 1(a), the magnetic sensor 4 is composed of a short horizontally long rectangular element substrate 40 and an IC chip 41 such as a Hall element or a magnetoresistive element arranged on an upper surface 40a of the element substrate 40.

Thus, such a magnetic sensor 4 is arranged on the bus bar 2, that is, at almost a central position of the upper surface 21a of the right bus bar 21, as shown in FIG. 1. More specifically, as shown in FIG. 1(b), the magnetic sensor 4 is arranged at a position floating from the right bus bar 21, that is, at a position spaced apart from the right bus bar 21 in the vertical upward direction (upward direction in the figure) so as not to come in contact with the upper surface 21a of the right bus bar 21. In order to fix this position, as shown in FIG. 1(b), a resin 5 having a rectangular cross sectional shape is arranged to fill a space between a lower surface 40b of the element substrate 40 of the magnetic sensor 4 and the upper surface 21a of the right bus bar 21, and the lower surface 40b of the element substrate 40 and the upper surface 21a of the right bus bar 21 are molded with the resin 5 or applied with resin casing. Thereby, as shown in FIG. 1(b), the magnetic sensor 4 is arranged at a position floating from the right bus bar 21 so as not to come in contact with the upper surface 21a of the right bus bar 21.

Thus, in this way, the magnetic sensor 4 is provided on the path of the bus bar 2 through which the current I flows, as shown in FIG. 1(a). That is, when the current I to be measured flows through the bus bar 2 installed in an inverter, a battery, or the like from the right side surface 21d side of the right bus bar 21 toward the left side surface 20c side of the left bus bar 20 as shown in FIG. 1(a), a magnetic-field component M is generated in a direction perpendicular to the current I flowing through the bus bar 2. At this time, the IC chip 41 of the magnetic sensor 4 detects the magnetic-field component M, and then the current value can be measured.

Accordingly, in the present embodiment, the current sensors with different current detection methods (shunt resistor 3, magnetic sensor 4) are provided on the path of one bus bar 2, that is, the bus bar 2 through which the current I to be measured flows from the right side surface 21d side of the right bus bar 21 toward the left side surface 20c side of the left bus bar 20. In this way, the current sensors with different detection methods can be used to provide redundancy so that even if one current sensor is damaged, the current detection can be continued using another current sensor as in the conventional case.

Further, in the present embodiment, since the current sensors with different current detection methods (shunt resistor 3, magnetic sensor 4) are provided on one bus bar 2, the installation space can be reduced and the current detector can be made less susceptible to the heat generated by the current I flowing through the bus bar 2. That is, in the conventional case, since a shunt resistor and a magnetic sensor are merely arranged in parallel, in a single bus bar provided with the magnetic sensor, there is the disadvantage that the installation space increases and in a single bus bar provided with the shunt resistor, there is the disadvantage of being susceptible to the heat generated by the current flowing through the bus bar. However, in the present embodiment, since the current sensors with different current detection methods (shunt resistor 3, magnetic sensor 4) are provided on the single bus bar 2, the installation space can be reduced, and further by providing the magnetic sensor 4 less susceptible to heat generation, the current detector can be made less susceptible to heat generation than a single bus bar provided with only the shunt resistor as in the conventional case. Therefore, in the present embodiment, the disadvantages of the current sensors with different current detection methods (shunt resistor 3, magnetic sensor 4) can be mutually complemented.

Therefore, according to the present embodiment, the current detector can provide redundancy and mutually complement the disadvantages of the current sensors with different detection methods.

### <Description of Modification>

Note that the current detector 1 shown in the present embodiment is merely an example, and various modifications and changes can be made within the scope of the gist of the present invention described in the claims. For example, in the present embodiment, an example has been shown in which only one shunt resistor 3 and only one magnetic sensor 4 are provided on the single bus bar 2. However, the present invention is not limited thereto, and a plurality of the shunt resistors 3 and a plurality of the magnetic sensors 4 may be provided, or other current sensors may be provided.

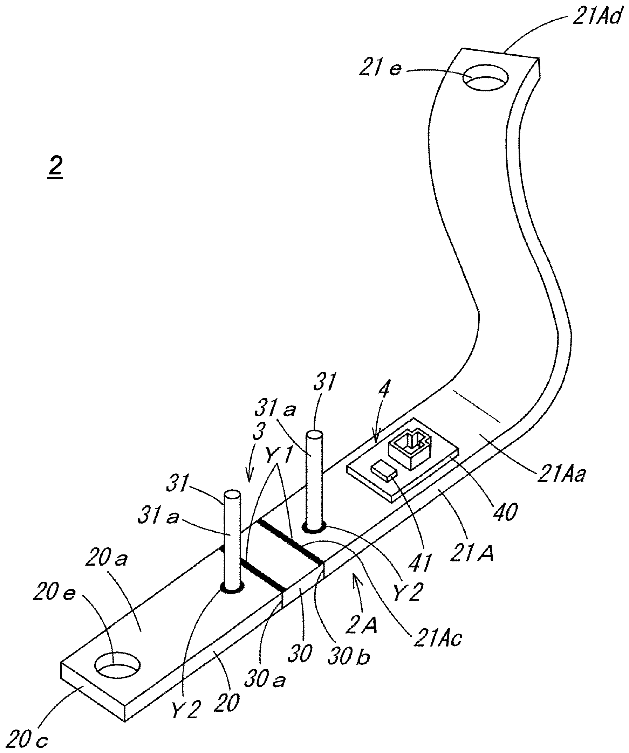

Also, the shape of the bus bar 2 illustrated in the present embodiment is merely an example, and the bus bar 2 may have any shape. For example, in the present embodiment, an example has been shown in which the left through hole 20e and the right through hole 21e are provided, but they do not have to be provided. Further, the bus bar 2 may have a U shape or a lateral U shape, or may have a shape like a bus bar 2A of a current detector 1A as shown in FIG. 2. This point will be described specifically with reference to FIG. 2. Note that the same configurations as the current detector 1 shown in FIG. 1 are denoted by the same reference signs, and detailed description thereof will be omitted.

The only difference between the current detector 1A shown in FIG. 2 and the current detector 1 shown in FIG. 1 is the shape of the bus bar, and other than that, they are the same. That is, the bus bar 2A shown in FIG. 2 is made of metal such as copper, and is composed of a left bus bar 20 and a right bus bar 21A. The right bus bar 21A is formed into a shape to which a bending process is applied, and is formed linearly from a central part to a left side surface 21Ac side of the right bus bar 21A and the bending process is applied so as to have a rising shape from the central part toward a right side surface 21Ad side of the right bus bar 21A. The left side surface 21Ac of the right bus bar 21A is joined to the right side surface 30b of the resistive element 30 by welding Y1. Further, on the upper surface 21a on the left side surface 21Ac side of the right bus bar 21A, the shaft portion 31a of the measurement terminal 31 is provided in a standing state by being joined by welding Y2, and the magnetic sensor 4 is provided on the linear portion from the central part to the left side surface 21Ac side of the right bus bar 21A. Thus, even with such a shape of the bus bar 2A, the current detector can provide redundancy and mutually complement the disadvantages of the current sensors with different detection methods.

Incidentally, in FIG. 2, an example has been shown in which the magnetic sensor 4 is provided on the linear portion from the central part to the left side surface 21Ac side of the right bus bar 21A. However, the present invention is not limited thereto, and the magnetic sensor 4 may be provided on the bent portion. However, the present invention is not limited thereto, and the magnetic sensor 4 may be provided on the bent portion. However, the magnetic sensor 4 is preferably provided on the linear portion. This is because the magnetic sensor 4 requires processing such as applying shielding for preventing erroneous measurements or casing for preventing physical damage and this processing is difficult when the magnetic sensor 4 is provided on the bent portion. Thus, since the processing such as applying shielding or casing is facilitated, the magnetic sensor 4 is preferably provided on the linear portion.

### Reference Signs List

1, 1A current detector
2, 2A bus bar
20c left side surface (the other end surface)
20e left through hole
21d, 21Ad right side surface (one end surface)
21e right through hole
3 shunt resistor (current sensor)
30 resistive element
4 magnetic sensor (current sensor)
I current
M magnetic-field component

## Claims

1. A current detector having a bus bar through which a current to be measured flows, wherein
current sensors detecting the current by different detection methods are provided on a path of the bus bar through which the current flows from one end surface side to another end surface side of the bus bar.

2. The current detector according to claim 1, wherein the current sensors include
a magnetic sensor detecting a magnetic-field component generated by the current flowing through the bus bar, and
a shunt resistor allowing the current flowing through the bus bar to flow through a resistive element and detecting a magnitude of the current from a voltage across the resistive element.

3. The current detector according to claim 2, wherein the magnetic sensor is provided at a linearly-formed position of the path of the bus bar.
